# EUROPEAN PATENT SPECIFICATION

(11) **EP 3 826 446 B1**
(45) Date of publication and mention of the grant of the patent: **25.11.2026**
(21) Application number: 18927182.8
(22) Date of filing: 19.07.2018
(51) Int. Cl.: H05K 13/02

(54) **COMPONENT SUPPLY DEVICE**
KOMPONENTENZUFÜHRUNGSVORRICHTUNG
DISPOSITIF D'ALIMENTATION EN COMPOSANTS

(43) Date of publication of application: 26.05.2021
(73) Proprietor: Fuji Corporation, Chiryu-shi, Aichi 472-8686 (JP)
(72) Inventor: MORIKAWA, Shunji, Chiryu-shi, Aichi 472-8686 (JP)
(74) Representative: Grünecker Patent- und Rechtsanwälte PartG mbB
(86) International application number: PCT/JP2018/027044
(87) International publication number: WO 2020/016978

(56) References cited:
- EP-A2- 1 959 721
- JP-A- 2012 156 426
- JP-A- 2014 167 955
- JP-A- H02 178 998
- US-A1- 2013 045 066
- US-B1- 6 199 272

## Description

### Technical Field

The present invention relates to a component supply device of a working machine that mounts component on a board using a mounting head.

### Background Art

As described in the following patent literature, a component supply device includes a device that supplies components from a tray set in a supply position, so-called a tray type component supply device. JP-A-2009-147197 discloses a tray component supply device of a working machine. In this tray component supply device, multiple trays are housed in housing 30, from which one tray is moved to supply position 88. The components are sequentially picked up by suction from the tray, and when the pick up by suction is completed, the tray is returned to the housing. JP-A-10-341098 also discloses a component supply device of a working machine. In this tray component supply device, in order to supply the components to a head of the working machine, the tray is moved in a direction parallel to a conveyance direction of the board and the components are supplied at any stop position. The component supply device of US 6 199 272 B1 has a comparable configuration, wherein the tray can be stopped in any position of a transfer path parallel to the conveyance direction of the board and the pickup area covers almost all of the transfer path.

### Summary of the Invention

### Technical Problem

However, in the supply device of JP-A-2009-147197, the supply position is fixed. As a result, when a head waiting time occurs because of a head movement speed faster than a tray movement speed, the components cannot be efficiently supplied. In addition, JP-A-10-341098 does not specifically disclose how the supply position is determined. Then, in the configuration in JP-A-10-341098, a complicated control is required to adjust the supply device and the mounting device. Therefore, in the tray type component supply device, an object is to appropriately supply the components from the tray with a simple configuration.

### Solution to Problem

In order to solve the object described above, the present specification discloses a component supply device of a work machine according to claim 1.

### Advantageous Effect of the Invention

According to the present disclosure, a supply position by a tray is set to be an advanced position or an intermediate position according to at least one of the number of components planned to be picked up from the tray and the number of times of reciprocating operations from the tray to the board when a mounting head picks up the components from the tray to mount thereon. In this way, it is possible to appropriately the supply components from the tray with a simple configuration.

### Brief Description of Drawings

Fig. 1 is a perspective view illustrating a component mounter.
Fig. 2 is a perspective view illustrating a work head.
Fig. 3 is a plan view illustrating a component supply device in a state in which a shuttle is positioned in a retreat position.
Fig. 4 is a plan view illustrating the component supply device in a state in which the shuttle is positioned at a first shuttle position.
Fig. 5 is a block diagram illustrating a control device.
Fig. 6 is a plan view illustrating the component supply device in a state in which the shuttle is positioned at a second shuttle position.
Fig. 7 is a plan view illustrating the component supply device in a state in which the shuttle is positioned at a third shuttle position.
Fig. 8 is a plan view illustrating the component supply device in a state in which the shuttle is positioned at the second shuttle position in a modification example.

### Description of Embodiments

Hereinafter, as exemplary embodiments of the present invention, examples of the present invention will be described in detail with reference to the drawings.

### (A) First Example

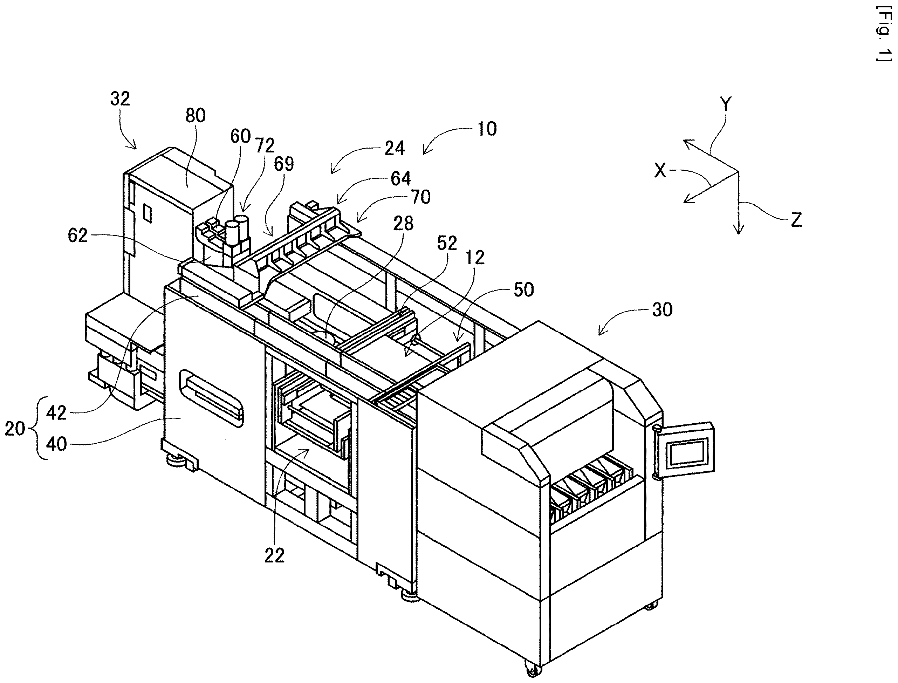

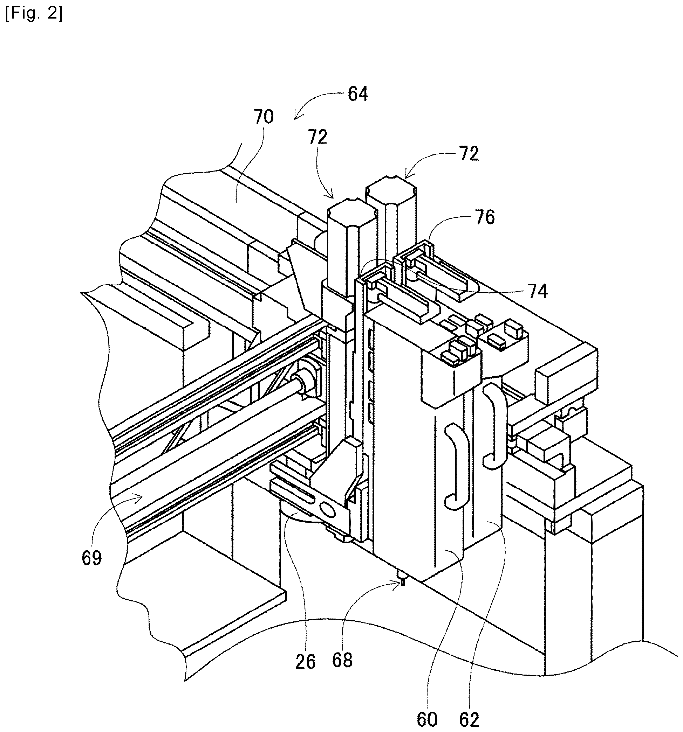

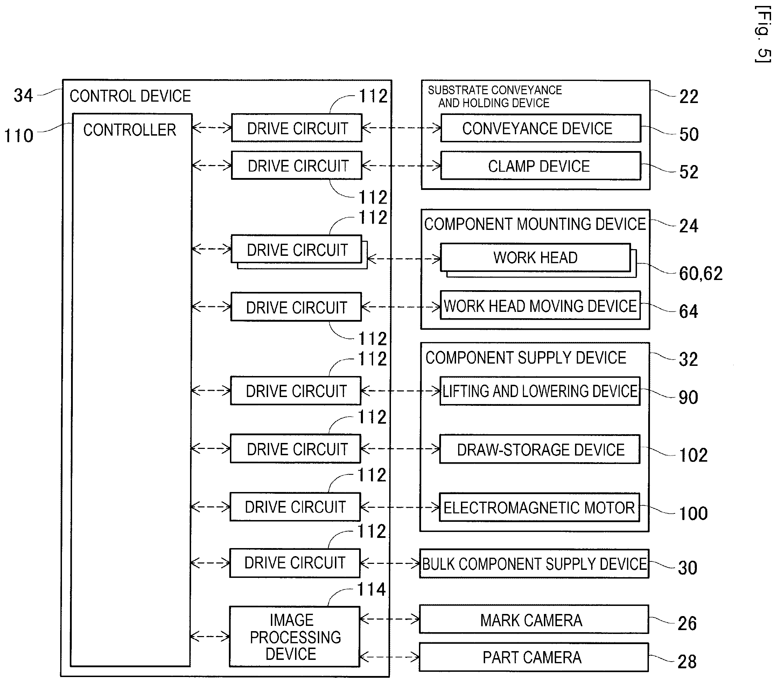

Fig. 1 illustrates component mounter 10. Component mounter 10 is a device for executing a mounting work of components on circuit substrate 12. Component mounter 10 includes device main body 20, substrate conveyance and holding device 22, component mounting device 24, mark camera (refer to Fig. 2) 26, part camera 28, bulk component supply device 30, component supply device 32, control device (refer to Fig. 5) 34. Examples of circuit substrate 12 include a circuit board, a substrate having a three-dimensional structure, and the like, and examples of the circuit board include a printed wiring board, a printed circuit board, and the like.

Device main body 20 is configured with frame section 40 and beam section 42 mounted on frame section 40. Substrate conveyance and holding device 22 is arranged in a center of frame section 40 in the longitudinal direction, and includes conveyance device 50 and clamp device 52. Conveyance device 50 is a device that conveys circuit substrate 12, and clamp device 52 is a device that holds circuit substrate 12. As a result, substrate conveyance and holding device 22 conveys circuit substrate 12 and fixedly holds circuit substrate 12 at a predetermined position. In the description hereinafter, the conveyance direction of circuit substrate 12 is referred to as an X direction, a horizontal direction perpendicular to that direction is referred to as a Y-direction, and a vertical direction is referred to as a Z-direction. That is, a width direction of component mounter 10 is X-direction, and the longitudinal direction is Y-direction.

Component mounting device 24 is arranged in beam section 42 and includes two work heads 60 and 62 and work head moving device 64. As illustrated in Fig. 2, each work head 60 and 62 includes suction nozzle 68, and holds the components by suction nozzle 68. In addition, work head moving device 64 includes X-direction moving device 69, Y-direction moving device 70, and Z-direction moving device 72. Then, two work heads 60 and 62 are integrally moved to any position on frame section 40 by X-direction moving device 69 and Y-direction moving device 70. In addition, work heads 60 and 62 are detachably mounted to sliders 74 and 76, and Z-direction moving device 72 individually moves sliders 74 and 76 in the vertical direction. That is, work heads 60 and 62 are individually moved in the up-down direction by Z-direction moving device 72.

Mark camera 26 is attached to slider 74 in a state of facing downward, and is moved to the X-direction, Y-direction, and Z-direction together with work head 60. As a result, mark camera 26 images any position on frame section 40. As illustrated in Fig. 1, part camera 28 is arranged in a state of facing upward between substrate conveyance and holding device 22 on frame section 40 and component supply device 32. In this way, part camera 28 images the components held in suction nozzle 68 of work heads 60 and 62.

As illustrated in Fig. 1, bulk component supply device 30 is arranged at an end portion on one side in the longitudinal direction of frame section 40. Bulk component supply device 30 is a device that aligns multiple components in a scattered state and supplies the components in the aligned state. That is, bulk component supply device 30 is a device that aligns multiple components of any posture to a predetermined posture, and supplies the components of the predetermined posture.

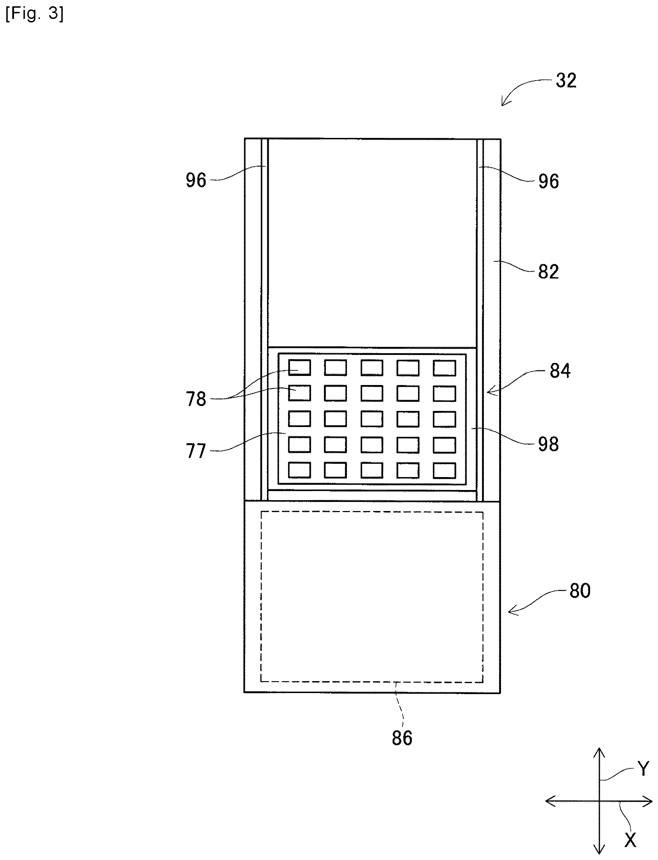

Component supply device 32 is arranged at the end portion on the other side of frame section 40 in the longitudinal direction. As illustrated in Fig. 3, component supply device 30 is a device that supplies component 78 in a state of being placed in tray 77, and includes tray storage 80, tray draw table 82, and tray moving device 84. Tray storage 80 is a tower type storage, and rack 86 is arranged inside tray storage 80 so as can be moved up and down. Rack 86 is generally box-shaped and has an open front surface. The inside of rack 86 is a shelf-shaped, and tray 77 is housed in each shelf. In addition, rack 86 moves to any height inside tray storage 80 by the operation of lifting and lowering device (refer to Fig. 5) 90.

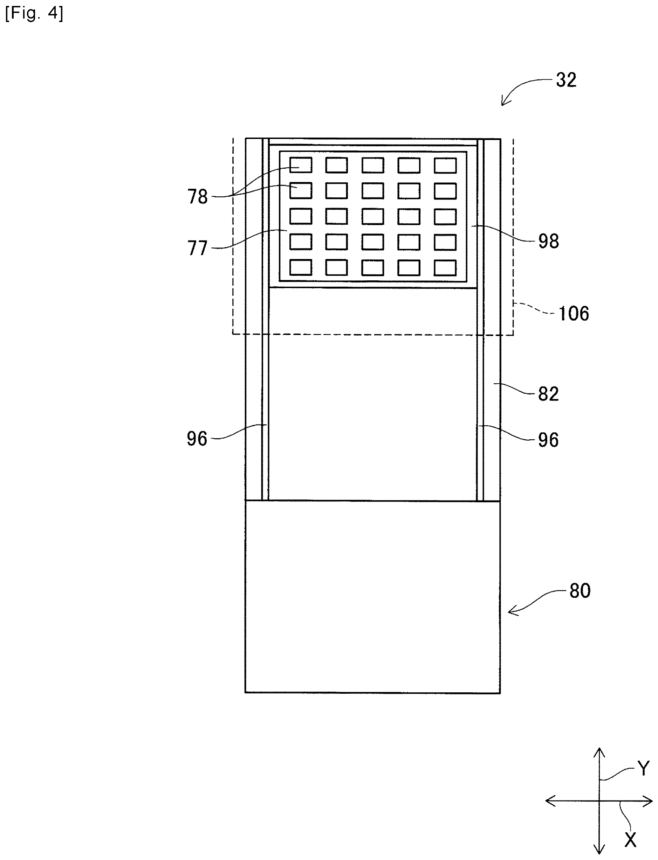

Tray draw table 82 is arranged on a front side of tray storage 80, and tray moving device 84 is arranged on tray draw table 82. Tray moving device 84 includes a pair of guide rails 96 and shuttle 98. A pair of guide rails 96 are fixed to the upper surface of tray draw table 82 so as to extend in the longitudinal direction, that is, the Y-direction, and shuttle 98 is slidably held by the pair of guide rails 96. Then, shuttle 98 slides to an arbitrary position on the upper surface of tray draw table 82 in the Y-direction by the operation of electromagnetic motor (refer to Fig. 5) 100. Shuttle 98 slides to any position between a position where shuttle 98 is closest to tray storage 80 as illustrated in Fig. 3 (hereinafter, referred to as "retreat position") and a position where shuttle 98 is farthest away from tray storage 80 as illustrated in Fig. 4.

Tray moving device 84 also further includes draw-storage device (refer to Fig. 5) 102. Drawer-storage device 102 is configured with a clamp (not illustrated) that grips tray 77 stored in a shelf positioned at a predetermined height of rack 86 and a moving mechanism (not illustrated) that moves the clamp in the longitudinal direction. As a result, by gripping tray 77 stored in the storage position of the shelf of rack 86 using the clamp in a state in which shuttle 98 is moved to the retreat position and by moving the clamp away from rack 86, tray 77 is drawn from the storage position of rack 86 onto shuttle 98. In addition, if tray 77 is placed on shuttle 98, by moving shuttle 98 to the retreat position, gripping tray 77 on shuttle 98 with the clamp, and moving the clamp closer to rack 86, tray 77 on shuttle 98 is stored in the storage position of rack 86.

Component supply device 32 is coupled to the end portion of frame section 40 in the longitudinal direction in a state in which tray draw table 82 is inserted into component mounter 10. Therefore, a part of tray draw table 82 on a side away from tray storage 80 is positioned inside a movement range of work heads 60 and 62 due to the operation of work head moving device 64. Incidentally, the movement range of work heads 60 and 62 is inside dotted line 106 in Fig. 4.

Examples of the components supplied by bulk component supply device 30 and component supply device 32 include electric components, configuration components for a solar cell, configuration components for a power module, and the like. In addition, the electric component includes a component having a lead such as a lead component, a component having no lead such as a square chip, and an atypical electric component.

As illustrated in Fig. 5, control device 34 includes controller 110, multiple drive circuits 112, and image processing device 114. Multiple drive circuits 112 are connected to the above-described conveyance device 50, clamp device 52, work heads 60 and 62, work head moving device 64, lifting and lowering device 90, electromagnetic motor 100, draw-storage device 102, and bulk component supply device 30. Controller 110 includes a CPU, ROM, RAM, and the like, and is mainly a computer, and is connected to multiple drive circuits 112. As a result, the operations of substrate conveyance and holding device 22, component mounting device 24, and the like are controlled by controller 110. Furthermore, controller 110 is also connected to image processing device 114. Image processing device 114 processes image data obtained by mark camera 26 and part camera 28, and controller 110 acquires various information from the image data.

In component mounter 10, a component mounting work is performed on circuit substrate 12 held by substrate conveyance and holding device 22 according to the above-described configuration. Specifically, circuit substrate 12 is conveyed to a work position, and is fixedly held by clamp device 52 at that position. Next, mark camera 26 moves above circuit substrate 12 and images circuit substrate 12. At this time, the image data obtained by imaging by mark camera 26 is transmitted to controller 110, and the image data is analyzed by controller 110. As a result, information regarding the holding position of circuit substrate 12 and the like is calculated.

In addition, bulk component supply device 30 or component supply device 32 supplies the components at a predetermined supply position, but here, the case where the components are supplied by component supply device 32 will be described. In component supply device 32, as described above, tray 77 stored in rack 86 of tray storage 80 is drawn out onto shuttle 98 moving to the retreat position. Then, by sliding shuttle 98 away from tray storage 80, that is, toward the inside of component mounter 10, tray 77 drawn out onto shuttle 98 positions within the movement range (inside dotted line 106 in Fig. 4) of work heads 60 and 62. As a result, component supply device 32 supplies components 78 in a state of being placed on tray 77.

In addition, when the component are supplied by component supply device 32, work heads 60 and 62 move to the component supply position, that is, above tray 77, and components 78 are picked up and held by suction nozzle 68. The work heads pick up hold the components in an order determined in advance by component data of a production program (job) (component size, pitch between the components, pick up order on the tray, and the like). Next, when components 78 are supplied by work heads 60 and 62, work heads 60 and 62 move above part camera 28, and components 78 held are imaged by part camera 28. At this time, the image data obtained by the imaging the components by part camera 28 is transmitted to controller 110, and the image data is analyzed by controller 110. As a result, information regarding the holding position of components 78 and the like by suction nozzle 68 is calculated.

In addition, controller 110 determines whether component 78 is suitable for a mounting work based on the image data of component 78. For example, when an outer edge of component 78 is recognized based on the image data and a chipping or the like occurs, it is determined that component 78 is a defective product and is not suitable for the mounting work. The component determined not to be suitable for the mounting work is discarded in a dust box (not illustrated), and work heads 60 and 62 move above tray 77 again to hold component from tray 77. On the other hand, when the outer edge of component 78 is recognized based on image data and no chipping or the like occurs, it is determined that component 78 is not a defective product and is suitable for the mounting work. Then, work heads 60 and 62 move above a mounting planned position on circuit substrate 12, and mount the held component on circuit substrate 12 in a state where an error of the holding position on circuit substrate 12 and the error of the holding position of the component are corrected.

In controller 110, it is also determined whether the holding position of component 78 by work heads 60 and 62 is deviated based on the image data, that is, whether work heads 60 and 62 correctly hold component 78. At this time, even when it is determined that work heads 60 and 62 do not correctly hold component 78, it is determined that component 78 is not suitable for the mounting work. Then, the component is discarded in the dust box, and work heads 60 and 62 move above tray 77 again to hold component from tray 77. On the other hand, when it is determined that work heads 60 and 62 correctly hold component 78, it is determined that component 78 is suitable for the mounting work. Then, the component is mounted on circuit substrate 12.

As described above, in component mounter 10, component 78 supplied in a state of being placed on tray 77 in component supply device 32 is held by work heads 60 and 62 and mounted on circuit substrate 12. Therefore, at the time of mounting work, when the component not placed in tray 77 becomes a mounting target component, the tray exchange work is performed by the operation of tray moving device 84 in component supply device 32. Specifically, for example, a case of mounting work will be described, in which, if an A component is placed in a first tray and a B component is placed in a second tray, the B component is mounted after the A component is mounted on circuit substrate 12.

In component supply device 32, first, the first tray is drawn out onto shuttle 98 by the operation of tray moving device 84, and shuttle 98 slides inward of component mounter 10 such that the first tray moves into the movement range of work heads 60 and 62. Then, the A component placed in the first tray is held by work heads 60 and 62, and the A component mounting work is executed. Next, when the A component mounting work is completed, shuttle 98 carrying the first tray moves to the retreat position, and the first tray is stored in tray storage 80. Subsequently, the second tray is drawn out onto shuttle 98 from tray storage 80, and shuttle 98 slides inward of component mounter 10 such that the second tray moves into the movement range of work heads 60 and 62. Then, the B component placed in the second tray is held by work heads 60 and 62, and the mounting work for the B component is executed.

As described above, when the component that is not placed in tray 77 becomes a mounting target component at the time of the mounting work, the tray exchange work is performed in component supply device 32. However, an operation speed of tray moving device 84 that executes the tray exchange work, that is, a movement speed of shuttle 98 and the draw and storage speed of the tray by draw-storage device 102, are slower compared with the movement speed of work heads 60 and 62. Therefore, at the time of tray exchange work, a waiting time of work heads 60 and 62 may occur, and the cycle time may become long. That is, for example, after the A component mounting work by work heads 60 and 62 is completed, even if work heads 60 and 62 try to hold the B component from the second tray, the second tray does not move to a working range of work heads 60 and 62, and thus, a delay of the components supply by the tray may occur. In such a case, work heads 60 and 62 need to wait until the second tray moves to the movement range of work heads 60 and 62, and the cycle time becomes long.

In consideration of such a problem, in component supply device 32, in order to shorten the time required for the tray exchange work, it is desirable to shorten a movement distance of the tray. That is, it is desirable to supply the components at a location close to tray storage 80. On the other hand, when the components are supplied at the location close to tray storage 80, since the component supply position is separated from circuit substrate 12, the distance between the component supply position and circuit substrate 12 becomes long. Therefore, the movement distance of work heads 60 and 62 at the time of mounting work becomes long, and the cycle time becomes long.

Therefore, at the time of component mounting work for the components supplied from one tray drawn out from tray storage 80, if the number of times of reciprocations of work heads 60 and 62 between the component supply position and circuit substrate 12 by component supply device 32 is small, the reduction of the time required for the tray exchange work is prioritized. That is, if the number of times of reciprocations of work heads 60 and 62 is small, component supply device 32 supplies the components at a location close to tray storage 80.

On the other hand, if the number of times of reciprocations of work heads 60 and 62 between the component supply position and circuit substrate 12 by component supply device 32 is large, it is desirable that component supply device 32 supplies the components at a location close to circuit substrate 12, that is, a location far from tray storage 80 while prioritizing the shortening of the movement distance of work heads 60 and 62. However, when the tray drawn from tray storage 80 is moved to a location far from tray storage 80, there is a problem in that a waiting time of work heads 60 and 62 may occur. Therefore, the component supply position when the component is first supplied from the tray is set to a location close to tray storage 80, and the subsequent component supply position is set to a location far from tray storage 80. That is, when the number of times of reciprocations of work heads 60 and 62 is large, component supply device 32 supplies the component at a location close to tray storage 80 at first, and then, supplies the component at a location far from tray storage 80. In this way, it is possible to achieve both suppression of the delay of the component supply by the tray and shortening of the movement distance of work heads 60 and 62.

That is, in component supply device 32, if the number of times of reciprocations of work heads 60 and 62 is less than a set number of times, by supplying the component at a location close to tray storage 80, the time required for the tray exchange work can be shortened. On the other hand, if the number of times of reciprocations of work heads 60 and 62 is equal to or larger than the set number of times, first, the component is supplied at a location close to tray storage 80, and then, the component is supplied at a location far from tray storage 80. In other words, by changing the component supply position, it is possible to achieve both suppression of the delay of the component supply by the tray and shortening of the movement distance of work heads 60 and 62.

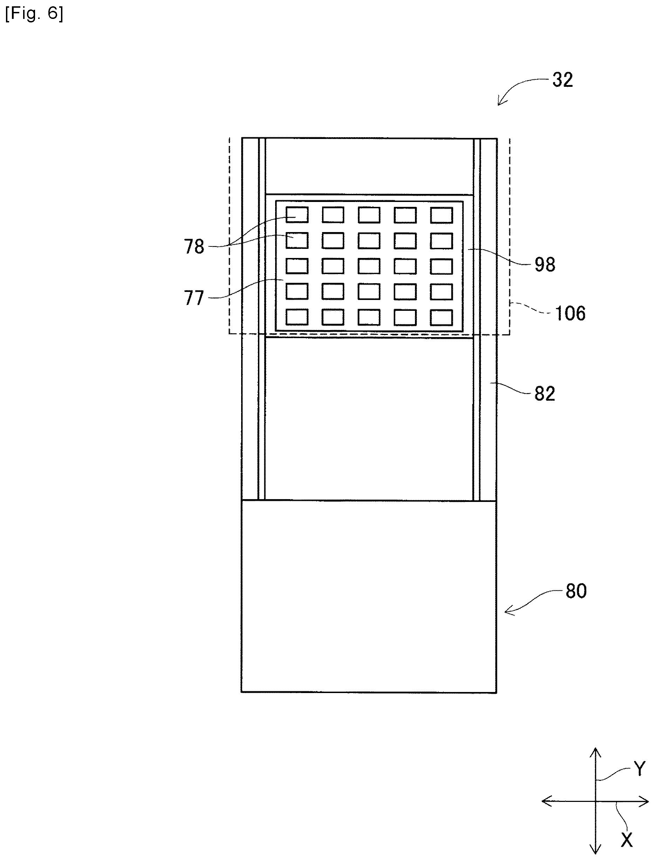

Specifically, the position of the tray when the component is supplied by component supply device 32, that is, the component supply position is set as two positions such as a position where shuttle 98 is farthest from tray storage 80 (hereinafter, referred to as a "first shuttle position") as illustrated in Fig. 4, the and a position closer to tray storage 80 than the first shuttle position (hereinafter, referred to as a "second shuttle position") as illustrated in Fig. 6. Tray 77 placed in shuttle 98 positioned in the first shuttle position is naturally positioned in the movement range (inside dotted line 106) of work heads 60 and 62, but tray 77 placed in shuttle 98 positioned in the second shuttle position is also positioned in the movement range (inside dotted line 106) of work heads 60 and 62. Then, if the number of times of reciprocations of work heads 60 and 62 is one, component supply device 32 supplies the component at the second shuttle position. That is, if the number of times of reciprocations of work heads 60 and 62 is one, the component supply position by the component supply device 32 is set to the second shuttle position. On the other hand, if the number of times of reciprocations of work heads 60 and 62 is equal to or more than 2, first, component supply device 32 supplies the component at the second shuttle position, and then, supplies the component at the first shuttle position. That is, if the number of times of reciprocations of work heads 60 and 62 is equal to or more than 2, the first component supply position by component supply device 32 is set to the second shuttle position, and the second and subsequent component supply positions by component supply device 32 are set to the first shuttle position.

Therefore, if the set number of times is set to 2 and the number of times of reciprocations of work heads 60 and 62 is one that is less than the set number of times, when the first tray is drawn out from tray storage 80 onto shuttle 98, shuttle 98 moves to the second shuttle position. Then, component supply device 32 supplies the A component at the second shuttle position. At this time, when the A component from the tray is held by work heads 60 and 62 and the supply of the A component from the first tray is completed, shuttle 98 is moved to the retreat position and the first tray is stored in tray storage 80. Then, the second tray is drawn out onto shuttle 98. As a result, the movement distance of the tray is shortened, and the time required for the tray exchange work is shortened, and thus, the delay of the component supply by the tray is suppressed. In addition, at the time of A component mounting work placed in the first tray, since work heads 60 and 62 make the round trip between the component supply position and circuit substrate 12 only one time, even if the distance between the component supply position and circuit substrate 12 becomes long, the effect on the delay of the cycle time is significantly small.

On the other hand, if the number of times of reciprocations of work heads 60 and 62 is equal to or more than two that is the set number of times, when the first tray is drawn out from tray storage 80 onto shuttle 98, shuttle 98 moves to the second shuttle position. Then, component supply device 32 supplies the A component at the second shuttle position. At this time, since the movement distance of the tray is short, the A component can be supplied without delaying the movement of work heads 60 and 62, or in a state in which the delay time for the movement of work heads 60 and 62 is as small as possible. Then, when the A component is held by work heads 60 and 62 from the first tray and work heads 60 and 62 move toward circuit substrate 12, shuttle 98 moves from the second shuttle position to the first shuttle position. Then, component supply device 32 supplies the A component at the first shuttle position.

Subsequently, when the held A component is mounted on circuit substrate 12, work head 60 holds the component from the tray at the first shuttle position. At this time, the movement distance of work head 60 is shorter than that in the case of holding the component from the tray at the second shuttle position. That is, the movement distance of work head 60 at the time of the first reciprocation of work head 60 becomes shorter than the movement distance of work head 60 at the time of the second round trip of head 60, it is possible to shorten the cycle time. Then, when work head 60 makes reciprocations after the third time between the component supply position and circuit substrate 12, and the A component mounting work is executed, similarly to the second time, the component is held from the tray at the first shuttle position. As a result, work heads 60 and 62 move multiple times with a short movement distance, and it is possible to effectively shorten the cycle time.

Then, when the supply of the A component from the first tray is completed, shuttle 98 moves to the retreat position, and the first tray is stored in tray storage 80. Then, the second tray is drawn out onto shuttle 98. As described above, by setting the component supply position when the component is first supplied from the first tray to be the second shuttle position, the movement distance of the tray is shortened and thus, it is possible to suppress the delay of the component supply due to the first tray. In addition, at the time of component supply from the first tray for the second time and thereafter, since the component supply position is changed from the second shuttle position to the first shuttle position, the movement distance of work heads 60 and 62 is shortened. In this way, when the component is first supplied from the first tray, the component supply position is set to be the second shuttle position, and when the component is supplied from the second tray to the second and subsequent times, the component supply position is set to be the first shuttle position, and therefore, it is possible to achieve both the suppression of the delay of the component supply by the tray and the shortening of the movement distance of work heads 60 and 62. In addition, work heads 60 and 62 can pick up components in a predetermined order in both the first shuttle position and the second shuttle position without using the complicated control.

In addition, in component mounter 10, two types of modes are prepared as a method for returning the tray that completed the supply of the component, to the retreat position in order to execute the tray exchange work. Specifically, a mode in which the tray is returned to the retreat position immediately after the supply of components from is completed (hereinafter, referred to as "first mode"), and a mode in which the tray is returned to the retreat position (hereinafter referred to as "second mode") if the supply of components from the tray is completed and it is determined that the supplied components are suitable for the mounting work, are prepared. Then, a selection button (not illustrated) for selecting either the first mode or the second mode is arranged in component mounter 10.

When the first mode is selected by operating this selection button, if the supply of the component from the tray is completed, the tray is immediately returned to the retreat position. That is, for example, if the number of times of reciprocations of work heads 60 and 62 is one, when the tray is drawn out from tray storage 80 onto shuttle 98, shuttle 98 moves to the second shuttle position. Then, at the second shuttle position, the components are held from the tray by work heads 60 and 62, and when the supply of the component from the tray is completed, shuttle 98 immediately moves toward the retreat position.

In addition, if the number of times of reciprocations of work heads 60 and 62 is equal to or more than two, and when the tray is drawn out from tray storage 80 onto shuttle 98, shuttle 98 moves to the second shuttle position. Then, at the second shuttle position, shuttle 98 moves to the first shuttle position after the components are held from the tray by work heads 60 and 62. Subsequently, at the first shuttle position, the components are held from the tray by work heads 60 and 62. Then, when the supply of the component from the tray is completed, shuttle 98 immediately moves toward the retreat position.

On the other hand, if the second mode is selected by operating the selection button, when the supply of the component from the tray is completed, the tray is not returned to the retreat position, and the tray is returned to the retreat position if it is determined that the component supplied from the tray is suitable for the mounting work. That is, for example, if the number of times of reciprocations of work heads 60 and 62 is one, when the tray is drawn out from tray storage 80 onto shuttle 98, shuttle 98 moves to the second shuttle position. Then, at the second shuttle position, the component is held from the tray by work heads 60 and 62. When holding the components from the tray, work heads 60 and 62 move above part camera 28 as described above, and the held component is imaged by part camera 28. Then, based on the image data obtained by that imaging, it is determined whether the component held by work heads 60 and 62 is suitable for the mounting work. At this time, if the component is suitable for mounting work, the component is mounted on circuit substrate 12, but if the component is not suitable for the mounting work, the component is not mounted on circuit substrate 12 and is discarded, and therefore, it is necessary to hold the component from the tray again.

Therefore, if the number of times of reciprocations of work heads 60 and 62 is one, the supply of the component from the tray at the second shuttle position is completed, and if it is determined that the component supplied from the tray is suitable for the mounting work, shuttle 98 moves to the retreat position from the second shuttle position. On the other hand, if the supply of the component from the tray at the second shuttle position is completed and if it is determined that the component supplied from the tray is not suitable for the mounting work, shuttle 98 stays at the second shuttle position. As a result, work heads 60 and 62 can hold the components from the tray again.

In addition, if the number of times of reciprocations of work heads 60 and 62 is equal to or more than two, and when the tray is drawn out from tray storage 80 onto shuttle 98, shuttle 98 moves to the second shuttle position. Then, at the second shuttle position, shuttle 98 moves to the first shuttle position after the components are held from the tray by work heads 60 and 62. Subsequently, at the first shuttle position, the components are held from the tray by work heads 60 and 62. Then, if the supply of the component from the tray is completed and it is determined that the component supplied from the tray is suitable for the mounting work, shuttle 98 moves toward the retreat position, but the movement from the first shuttle position to the retreat position makes the movement distance of the tray long. Therefore, the components held by work heads 60 and 62 are imaged by part camera 28, and the tray moves from the first shuttle position to the second shuttle position while the suitability of the component is determined based on the image data.

That is, at the first shuttle position, when the supply of the component from the tray is completed, shuttle 98 moves to the second shuttle position from the first shuttle position. Then, if it is determined that the component supplied from the tray is suitable for the mounting work, shuttle 98 moves to the retreat position from the second shuttle position. As a result, the movement distance of the tray is shortened, and thus, it is possible to shorten the time required for the tray exchange work. If it is determined that the component supplied from the tray is not suitable for the mounting work, shuttle 98 stays at the second shuttle position, and at the second shuttle position, work heads 60 and 62 hold the component from the tray again.

As described above, in component mounter 10, by preparing the first mode and the second mode as the method of returning the tray that completed the supply of the component to the retreat position, and by selecting the first mode, the tray that completed the supply of the component can be immediately returned to the retreat position, and thus, it is possible to shorten the time required for tray exchange work. On the other hand, by selecting the second mode, when the component supplied from the tray is not suitable for the mounting work, the component can be supplied from the tray again.

### (B) Second Example

In component mounter 10 in the first example, when the component is supplied from the tray for the first time, the component supply position is set to be the second shuttle position, and when the component is supplied from the tray for the second time and subsequently, the component supply position is set to be the first shuttle position. On the other hand, in component mounter 10 in a second example, when the component is supplied from the tray for the first time and when the component is finally supplied from the tray, the component supply position is set to be the second shuttle position, and when the component is supplied from the tray for the second and subsequent times except the last one, the component supply position is set to be the first shuttle position.

Specifically, if the number of times of reciprocations of work heads 60 and 62 is one, and when the tray is drawn out from tray storage 80 onto shuttle 98, shuttle 98 moves to the second shuttle position, as in the first example. Then, component supply device 32 supplies the component at the second shuttle position. Subsequently, when the component from the tray is held by work heads 60 and 62 and the supply of the component from the tray is completed, shuttle 98 is moved to the retreat position and the tray is stored in tray storage 80.

In addition, if the number of times of reciprocations of work heads 60 and 62 is two, the component is supplied from the tray at the second shuttle position that is the first time and the second time that is the last time. That is, when the tray is drawn out from tray storage 80 onto shuttle 98, shuttle 98 moves to the second shuttle position. Then, component supply device 32 supplies the component at the second shuttle position for the first time. At this time, even if the components are held by work heads 60 and 62 from the tray, shuttle 98 stays at the second shuttle position. Then, when the second supply of the components from the tray is completed, shuttle 98 moves to the retreat position and the tray is stored in tray storage 80.

In addition, if the number of times of reciprocations of work heads 60 and 62 is equal to or more than 3, the component is supplied from the tray at the second shuttle position for the first time, and the component is supplied from the tray at the first shuttle position after the second time. Then, the component is supplied from the tray at the second shuttle position. That is, for example, if the number of times of reciprocations of work heads 60 and 62 is 5, and the tray is drawn out from tray storage 80 onto shuttle 98, shuttle 98 moves to the second shuttle position. Then, component supply device 32 supplies the component at the second shuttle position for the first time. Next, shuttle 98 moves to the first shuttle position from the second shuttle position, and component supply device 32 performs the second to fourth supply of the components from the tray at the first shuttle position. Subsequently, when the fourth supply of the components from the tray is completed, shuttle 98 moves from the first shuttle position to the second shuttle position, component supply device 32 performs the fifth supply of the component from the tray, that is, the last supply of the components, at the second shuttle position. Then, when the fifth supply of the components from the tray is completed, shuttle 98 moves to the retreat position and the tray is stored in tray storage 80.

That is, in component mounter 10 in the second example, if the set number of times is set to 3 times and the number of times of reciprocations of work heads 60 and 62 is one time and two times which is less than the set number of times, component supply device 32 supplies the components at the second shuttle position. On the other hand, if the number of times of reciprocations of work heads 60 and 62 is equal to or more than 3 which is equal to or more than the set number of times, when the component is supplied from the tray for the first time and when the component is last supplied from the tray, component supply device 32 supplies the components at the second shuttle position, and when the component is supplied from the tray other than the first and last time, supplies component at the first shuttle position. As a result, the time required for the tray exchange work can be further shortened as compared with the first example, and thus, it is possible to effectively suppress the delay of the component supply by the tray.

Incidentally, in the examples described above, component mounter 10 is an example of a work machine. In this application, working machine and work machine are used as equivalents. Part camera 28 is an example of an imaging device. Component supply device 32 is an example of a component supply device. Work heads 60 and 62 are examples of mounting heads. Tray 77 is an example of a tray. Tray storage 80 is an example of a magazine. Tray moving device 84 is an example of a tray moving device. Controller 110 is an example of a supply position setting device, an image processing result acquisition device, and an intermediate position setting device. The first shuttle position is an example of an advanced position. The second shuttle position is an example of an intermediate position. The position of tray 77 stored in tray storage 80 is an example of a storage position.

The present invention is not limited to the examples described above, and can be embodied in various embodiments with various modifications and improvements based on the knowledge of those skilled in the art. Specifically, for example, when the component is supplied from the tray for last time, the component supply position may be set to be the second shuttle position, and when the component is supplied from the tray other than the last time, the component supply position may be set to be the first shuttle position.

Specifically, if the number of times of reciprocations of work heads 60 and 62 is one, and when the tray is drawn out from tray storage 80 onto shuttle 98 as in the example described above, shuttle 98 moves to the second shuttle position. Then, component supply device 32 supplies the component at the second shuttle position. Subsequently, when the supply of the component from the tray is completed, shuttle 98 moves to the retreat position, and the tray is stored in tray storage 80.

In addition, if the number of times of reciprocations of work heads 60 and 62 is equal to or more than 2, for example, if 5 times, and when the tray is drawn out from tray storage 80 onto shuttle 98, shuttle 98 moves to the first shuttle position. Then, component supply device 32 supplies the component at the first shuttle position for the first time. In addition, component supply device 32 performs the second to fourth supply of the component from the tray at the first shuttle position. Then, when the fourth supply of the component from the tray is completed, shuttle 98 moves to the second shuttle position from the first shuttle position, and component supply device 32 performs the fifth or last supply of the component from the tray at the second shuttle position. Then, when the fifth supply of the components from the tray is completed, shuttle 98 moves to the retreat position and the tray is stored in tray storage 80.

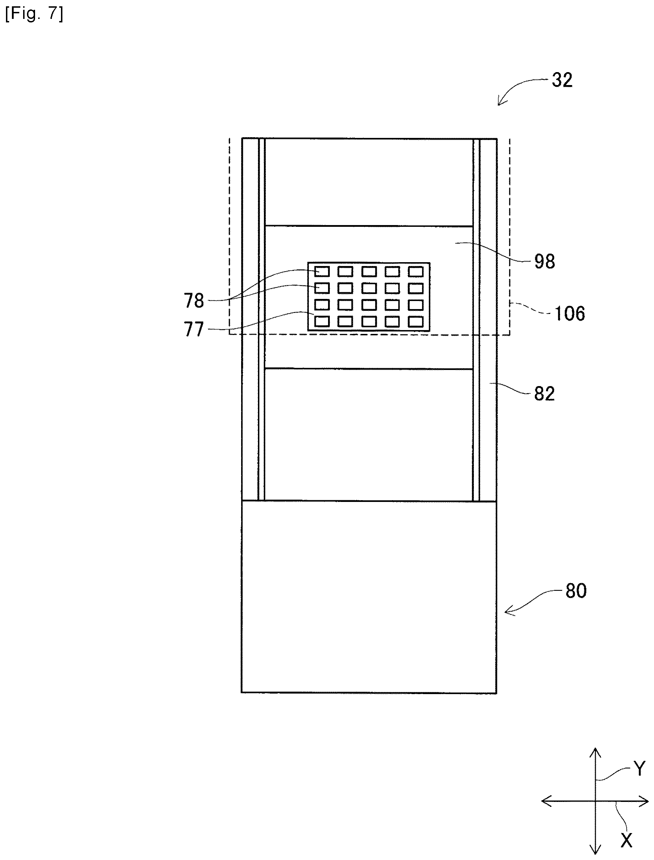

In addition, in the examples described above, two shuttle positions, that are the first shuttle position and the second shuttle position are set as the component supply positions, but in configurations not according to the claimed invention other shuttle positions may be set. For example, a shuttle position may be set according to the size of tray 77. That is, for example, as illustrated in Fig. 7, if the target component to be supplied is placed in tray 77 having a small size, the position of shuttle 98 in which the small sized tray 77 is positioned inside the movement range (inside dotted line 106) of work heads 60 and 62 may be set as the shuttle position. In this way, by setting the shuttle position according to the small size, the movement distance of the tray can be shortened. In addition, for example, the shuttle position may be set according to the size and number of components mounted on the tray instead of the size of tray 77.

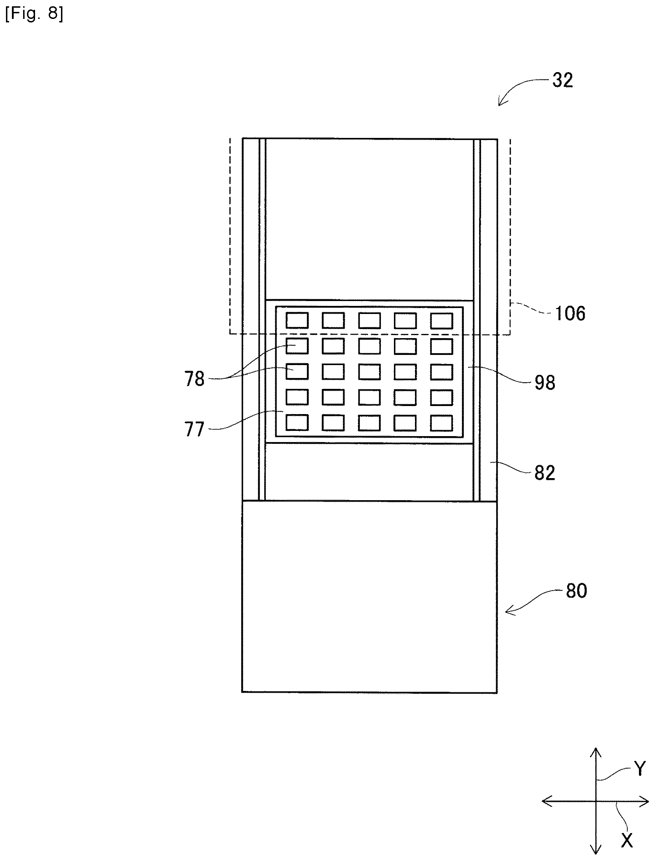

In addition, in the examples described above, the second shuttle position is set as the second shuttle position such that entire tray 77 is positioned in the movement range (inside dotted line 106) of work heads 60 and 62, however, the second shuttle position may be set such that a part of tray 77 is positioned in the movement range (inside dotted line 106) of work heads 60 and 62. That is, as illustrated in Fig. 8, the second shuttle position may be set such that a part of the components placed on tray 77 is positioned in the movement range (inside dotted line 106) of work heads 60 and 62. By setting the second shuttle position in this way, it is possible to further shorten the movement distance of the tray.

In addition, in the examples described above, the supply position of the components by the tray is set according to the number of times of reciprocations of work heads 60 and 62, however, the supply position of the components by the tray may be set according to the number of components planned to be picked up from the tray. For example, if the planned number of components is less than a set number, the second shuttle position may be set as the supply position, and if the planned number of components is greater than or equal to the set number, the first shuttle position may be set as the supply position.

### Reference Signs List

10: component mounter (work machine), 28: part camera (imaging device), 32: component supply device, 60: work head (mounting head), 62: work head (mounting head), 77: tray, 80: tray storage (magazine), 84: tray moving device, 110: controller (supply position setting device)(image processing result acquisition device)(intermediate position setting device)

## Claims

1. A component supply device (32) for a work machine (10) that mounts components on a board using a mounting head (60, 62), the device (32) comprising:
a magazine (80) configured to store a tray (77) in which multiple components that are sequentially picked up by the mounting head (60, 62) of the work machine (10) are placed, to be mounted on the board;
a storage position in the magazine (80), an advanced position outside the magazine (80) toward the direction of the work machine (10), and an intermediate position between the storage position and the advanced position being provided;
a tray moving device (84) configured to perform a tray supply operation, moving the tray (77) to a supply position such that the mounting head (60, 62) can pick up and mount the components on the board; and
a supply position setting device (110),
wherein the direction toward the work machine (10) is a direction intersecting a conveyance direction of the board in the work machine (10),
**characterized in that**
the supply position setting device (110) is configured to set either one supply position, the one supply position being the intermediate position, or two supply positions, the two supply positions being the intermediate position and the advanced position, depending on at least one of (a) the number of the components to be picked up from the tray (77) and (b) the number of times of reciprocating operations of the mounting head (60, 62) from the tray (77) to the board when the components are picked up from the tray (77) and are mounted.

2. The component supply device (32) according to claim 1,
wherein the supply position setting device (110) is configured to set the supply position according to the number of times of reciprocating operations of the mounting head (60, 62), and if the number of times of reciprocating operations of the mounting head (60, 62) is less than a set number of times, one supply position is set, the one supply position being the intermediate position.

3. The component supply device (32) according to claim 2,
wherein the supply position setting device (110) is configured to perform at least one of (a) setting the supply position to be the intermediate position that is a case of a first tray supply operation in which the tray (77) is moved to the supply position such that the mounting head (60, 62) can pick up and mount the components on the board, and setting the supply position to be the advanced position that is a case of a second tray supply operation performed after the first tray supply operation, and (b) setting the supply position to be the advanced position that is a case of a immediately previous tray supply operation performed immediately before a last tray supply operation, and after that, setting the supply position to be the intermediate position that is a case of the last tray supply operation, if the number of times of reciprocating operations of the mounting head is equal to or greater than the set number of times.

4. The component supply device (32) according to any one of claims 1 to 3, further comprising: an image processing result acquisition device (110) configured to acquire an image processing result from an imaging device (28) of the work machine (10), and to determine whether the component picked up by the mounting head (60, 62) is a component suitable for the mounting work based on the image processing result,
wherein the tray moving device (84) is configured to stop the tray (77) at the supply position until the determination by the image processing result acquisition device (110) is completed.

5. The component supply device (32) according to any one of claims 1 to 4, further comprising: an intermediate position setting device (110) configured to set a position of the intermediate position according to at least one of a size of the tray (77), a size of the component mounted on the tray (77), and the number of the components.

## Patentansprüche

1. Komponentenzuführungsvorrichtung (32) für eine Arbeitsmaschine (10), die Komponenten unter Verwendung eines Bestückungskopfes (60, 62) auf einer Platine bestückt, wobei die Vorrichtung (32) umfasst:
ein Magazin (80), das dazu eingerichtet ist, ein Tablett (77) zu lagern, auf dem mehrere Komponenten angeordnet sind, die nacheinander von dem Bestückungskopf (60, 62) der Arbeitsmaschine (10) aufgenommen werden, um auf der Platine bestückt zu werden;
wobei eine Lagerposition in dem Magazin (80), eine vorgeschobene Position außerhalb des Magazins (80) in Richtung zur Arbeitsmaschine (10) hin und eine Zwischenposition zwischen der Lagerposition und der vorgeschobenen Position vorgesehen sind;
eine Tablettbewegungsvorrichtung (84), die dazu eingerichtet ist, einen Tablettzuführvorgang durchzuführen, bei dem das Tablett (77) zu einer Zuführposition bewegt wird, sodass der Bestückungskopf (60, 62) die Komponenten aufnehmen und auf der Platine bestücken kann; und
eine Zuführpositionseinstellvorrichtung (110),
wobei
die Richtung zur Arbeitsmaschine (10) hin eine Richtung ist, die eine Transportrichtung der Platine in der Arbeitsmaschine (10) schneidet,
**dadurch gekennzeichnet, dass**
die Zuführpositionseinstellvorrichtung (110) dazu eingerichtet ist, entweder eine Zuführposition, wobei die eine Zuführposition die Zwischenposition ist, oder zwei Zuführpositionen einzustellen, wobei die zwei Zuführpositionen die Zwischenposition und die vorgeschobene Position sind, in Abhängigkeit von wenigstens einem von (a) der Anzahl der von dem Tablett (77) aufzunehmenden Komponenten und (b) der Anzahl von Hin- und Herbewegungen des Bestückungskopfes (60, 62) von dem Tablett (77) zu der Platine, wenn die Komponenten von dem Tablett (77) aufgenommen und bestückt werden.

2. Komponentenzuführungsvorrichtung (32) nach Anspruch 1,
wobei die Zuführpositionseinstellvorrichtung (110) dazu eingerichtet ist, die Zuführposition gemäß der Anzahl von Hin- und Herbewegungen des Bestückungskopfes (60, 62) einzustellen, und wenn die Anzahl von Hin- und Herbewegungen des Bestückungskopfes (60, 62) kleiner als eine festgelegte Anzahl ist, eine Zuführposition eingestellt wird, wobei die eine Zuführposition die Zwischenposition ist.

3. Komponentenzuführungsvorrichtung (32) nach Anspruch 2,
wobei die Zuführpositionseinstellvorrichtung (110) dazu eingerichtet ist, wenigstens eines von (a) einem Einstellen der Zuführposition auf die Zwischenposition, was ein Fall eines ersten Tablettzuführvorgangs ist, bei dem das Tablett (77) zu der Zuführposition bewegt wird, sodass der Bestückungskopf (60, 62) die Komponenten aufnehmen und auf der Platine bestücken kann, und einem Einstellen der Zuführposition auf die vorgeschobene Position, was ein Fall eines zweiten Tablettzuführvorgangs ist, der nach dem ersten Tablettzuführvorgang durchgeführt wird, und (b) einem Einstellen der Zuführposition auf die vorgeschobene Position, was ein Fall eines unmittelbar vorhergehenden Tablettzuführvorgangs ist, der unmittelbar vor einem letzten Tablettzuführvorgang durchgeführt wird, und danach einem Einstellen der Zuführposition auf die Zwischenposition, was ein Fall des letzten Tablettzuführvorgangs ist, durchzuführen, wenn die Anzahl von Hin- und Herbewegungen des Bestückungskopfes größer als oder gleich der festgelegten Anzahl ist.

4. Komponentenzuführungsvorrichtung (32) nach einem der Ansprüche 1 bis 3, ferner umfassend:
eine Bildverarbeitungsergebnis-Erfassungsvorrichtung (110), die dazu eingerichtet ist, ein Bildverarbeitungsergebnis von einer Bildaufnahmevorrichtung (28) der Arbeitsmaschine (10) zu erfassen und basierend auf dem Bildverarbeitungsergebnis zu bestimmen, ob die von dem Bestückungskopf (60, 62) aufgenommene Komponente eine für die Bestückungsarbeit geeignete Komponente ist,
wobei die Tablettbewegungsvorrichtung (84) dazu eingerichtet ist, das Tablett (77) an der Zuführposition anzuhalten, bis die Bestimmung durch die Bildverarbeitungsergebnis-Erfassungsvorrichtung (110) abgeschlossen ist.

5. Komponentenzuführungsvorrichtung (32) nach einem der Ansprüche 1 bis 4, ferner umfassend:
eine Zwischenpositionseinstellvorrichtung (110), die dazu eingerichtet ist, eine Position der Zwischenposition gemäß wenigstens einem von einer Größe des Tabletts (77), einer Größe der auf dem Tablett (77) bestückten Komponente und der Anzahl der Komponenten einzustellen.

## Revendications

1. Dispositif d'alimentation en composants (32) pour une machine de travail (10) qui monte des composants sur une carte à l'aide d'une tête de montage (60, 62), le dispositif (32) comprenant :
un magasin (80) configuré pour stocker un plateau (77) sur lequel sont placés plusieurs composants qui sont prélevés successivement par la tête de montage (60, 62) de la machine de travail (10), afin d'être montés sur la carte ;
une position de stockage dans le magasin (80), une position avancée à l'extérieur du magasin (80) dans la direction vers la machine de travail (10), et une position intermédiaire entre la position de stockage et la position avancée étant prévues ;
un dispositif de déplacement de plateau (84) configuré pour effectuer une opération d'alimentation de plateau, déplaçant le plateau (77) vers une position d'alimentation de telle sorte que la tête de montage (60, 62) puisse prélever et monter les composants sur la carte ; et
un dispositif de réglage de position d'alimentation (110),
dans lequel
la direction vers la machine de travail (10) est une direction coupant une direction de transport de la carte dans la machine de travail (10),
**caractérisé en ce que**
le dispositif de réglage de position d'alimentation (110) est configuré pour régler soit une position d'alimentation, ladite position d'alimentation étant la position intermédiaire, soit deux positions d'alimentation, les deux positions d'alimentation étant la position intermédiaire et la position avancée, en fonction d'au moins un parmi (a) le nombre de composants à prélever du plateau (77) et (b) le nombre de mouvements de va-et-vient de la tête de montage (60, 62) du plateau (77) vers la carte lorsque les composants sont prélevés du plateau (77) et sont montés.

2. Dispositif d'alimentation en composants (32) selon la revendication 1,
dans lequel le dispositif de réglage de position d'alimentation (110) est configuré pour régler la position d'alimentation en fonction du nombre de mouvements de va-et-vient de la tête de montage (60, 62), et, si le nombre de mouvements de va-et-vient de la tête de montage (60, 62) est inférieur à un nombre prédéfini, une position d'alimentation est réglée, ladite position d'alimentation étant la position intermédiaire.

3. Dispositif d'alimentation en composants (32) selon la revendication 2,
dans lequel le dispositif de réglage de position d'alimentation (110) est configuré pour effectuer au moins l'un parmi (a) le réglage de la position d'alimentation sur la position intermédiaire, ce qui est un cas d'une première opération d'alimentation de plateau dans laquelle le plateau (77) est déplacé vers la position d'alimentation de telle sorte que la tête de montage (60, 62) puisse prélever et monter les composants sur la carte, et le réglage de la position d'alimentation sur la position avancée, ce qui est un cas d'une deuxième opération d'alimentation de plateau effectuée après la première opération d'alimentation de plateau, et (b) le réglage de la position d'alimentation sur la position avancée, ce qui est un cas d'une opération d'alimentation de plateau immédiatement précédente effectuée immédiatement avant une dernière opération d'alimentation de plateau, et, après cela, le réglage de la position d'alimentation sur la position intermédiaire, ce qui est un cas de la dernière opération d'alimentation de plateau, si le nombre de mouvements de va-et-vient de la tête de montage est supérieur ou égal au nombre prédéfini.

4. Dispositif d'alimentation en composants (32) selon l'une quelconque des revendications 1 à 3, comprenant en outre :
un dispositif d'acquisition de résultats de traitement d'image (110) configuré pour acquérir un résultat de traitement d'image provenant d'un dispositif de capture d'image (28) de la machine de travail (10), et pour déterminer, sur la base du résultat de traitement d'image, si le composant prélevé par la tête de montage (60, 62) est un composant approprié pour l'opération de montage,
dans lequel le dispositif de déplacement de plateau (84) est configuré pour arrêter le plateau (77) à la position d'alimentation jusqu'à ce que la détermination par le dispositif d'acquisition de résultats de traitement d'image (110) soit achevée.

5. Dispositif d'alimentation en composants (32) selon l'une quelconque des revendications 1 à 4, comprenant en outre :
un dispositif de réglage de position intermédiaire (110) configuré pour régler une position de la position intermédiaire en fonction d'au moins un parmi une taille du plateau (77), une taille du composant monté sur le plateau (77) et le nombre de composants.
